(19) Europäisches Patentamt
European Patent Office
Office européen des brevets

(11) EP 4 223 850 A1

(12) EUROPEAN PATENT APPLICATION
published in accordance with Art. 153(4) EPC

(43) Date of publication:
09.08.2023 Bulletin 2023/32

(21) Application number: 22749981.1

(22) Date of filing: 28.01.2022

(51) International Patent Classification (IPC):
*C09J 11/04* (2006.01) *C09J 201/00* (2006.01)
*C08K 3/013* (2018.01) *C08K 5/29* (2006.01)
*C08K 3/08* (2006.01)

(52) Cooperative Patent Classification (CPC):
**C08K 3/013; C08K 3/08; C08K 5/29; C09J 11/04; C09J 201/00**

(86) International application number:
**PCT/KR2022/001597**

(87) International publication number:
**WO 2022/169231 (11.08.2022 Gazette 2022/32)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **05.02.2021 KR 20210017013**

(71) Applicant: **Lg Chem, Ltd.**
**Seoul 07336 (KR)**

(72) Inventors:
- **KIM, Hye Jin**
  **Daejeon 34122 (KR)**
- **JUNG, Je Sik**
  **Daejeon 34122 (KR)**
- **PARK, Hyoung Sook**
  **Daejeon 34122 (KR)**
- **WON, Jin Hyeok**
  **Daejeon 34122 (KR)**
- **HONG, Sung Bum**
  **Daejeon 34122 (KR)**
- **LEE, Sol Yi**
  **Daejeon 34122 (KR)**
- **CHOI, Jong Hun**
  **Daejeon 34122 (KR)**
- **SEO, Sang Hyuk**
  **Daejeon 34122 (KR)**
- **JUNG, Jae Min**
  **Daejeon 34122 (KR)**

(74) Representative: **Hoffmann Eitle**
**Patent- und Rechtsanwälte PartmbB**
**Arabellastraße 30**
**81925 München (DE)**

(54) **COMPOSITION**

(57) According to the present invention, it is possible to provide a composition comprising a resin component and a filler component, which achieves a low specific gravity effect in a state where a filler is filled in a high content and in a state where realization of physical properties by filling of the filler is sufficiently secured, and has improved storage stability without deterioration of physical properties such as a thermal conductivity, and a product comprising a heating element and the composition or a cured product thereof in thermal contact with the heating element.



Processed by Luminess, 75001 PARIS (FR)

## Description

[Technical Field]

Cross-Citation with Related Applications

This application claims the benefit of priority based on Korean Patent Application No. 10-2021-0017013 dated February 5, 2021, the disclosure of which is incorporated herein by reference in its entirety.

Technical Field

The present application relates to a composition and a product including thereof.

[Background Art]

By blending a filler with a composition capable of forming an adhesive or pressure-sensitive adhesive, it is possible to form a cured product having desired physical properties. In order to secure the physical properties by the filler, it is necessary to introduce the filler in a high content into the composition. However, since the commonly used filler has a high specific gravity, the specific gravity of the composition increases when a high-content filler is introduced, whereby there are problems that it is difficult to reduce the weight of the applied product and the use is limited.

For example, an alumina filler has a high thermal conductivity, but has a high specific gravity, so that when the alumina filler is introduced in a high content for a high heat dissipation effect, it is difficult to reduce the weight of the product. In addition, when the alumina filler is introduced in a low content in order to lower the specific gravity, there is a problem that the heat dissipation effect is deteriorated.

Therefore, it is required to develop a composition that can be filled with a filler in a high content, and thus can be used for various applications due to its low specific gravity while sufficiently ensuring realization of physical properties (e.g., heat dissipation performance).

[Disclosure]

[Technical Problem]

The present application is intended to provide a composition capable of achieving a low specific gravity effect in a state where a filler is filled in a high content, and in a state where realization of physical properties by filling of the filler is sufficiently secured.

In addition, the present application is intended to provide a composition having excellent storage stability without deterioration of physical properties such as a thermal conductivity.

[Technical Solution]

Among physical properties mentioned in this specification, the physical properties in which the measured temperature affects the physical properties are those measured at room temperature unless otherwise specified.

In this specification, the term "room temperature" is a natural temperature without heating and cooling, which means, for example, any temperature within a range of about 10°C to 30°C, for example, a temperature of about 15°C, about 18°C, about 20°C, about 23°C or about 25°C or so. Also, in this specification, the unit of temperature is °C, unless otherwise specified.

Among physical properties mentioned in this specification, when the measured pressure affects the result, the relevant physical property is a physical property measured at normal pressure, unless otherwise specified. The term "normal pressure" is a natural pressure without being pressurized or depressurized, in which usually about 1 atmosphere or so is referred to as normal pressure.

The term "alkyl group" or "alkylene group" as used herein may mean a linear or branched acyclic alkyl group or alkylene group having 1 to 20 carbon atoms, or 1 to 16 carbon atoms, or 1 to 12 carbon atoms, or 1 to 8 carbon atoms, or 1 to 6 carbon atoms, unless otherwise described.

The terms "alkenyl group" or "alkenylene group" as used herein may mean a linear or branched acyclic alkenyl group or alkenylene group having 2 to 20 carbon atoms, or 2 to 16 carbon atoms, or 2 to 12 carbon atoms, or 2 to 8 carbon atoms, or 2 to 6 carbon atoms, unless otherwise described.

The term "alkynyl group" or "alkynylene group" as used in the present application may mean a linear or branched acyclic alkynyl group or alkynylene group having 2 to 20 carbon atoms, or 2 to 16 carbon atoms, or 2 to 12 carbon atoms,

or 2 to 8 carbon atoms, or 2 to 6 carbon atoms, unless otherwise described.

The term "carboxylic acid-derived unit" as used herein may mean a part excluding a carboxyl group in a carboxylic acid compound. Similarly, the term "polyol-derived unit" as used herein may mean a part excluding a hydroxyl group in a polyol compound structure.

In the present application, the term "D50 particle size" is a particle diameter (median diameter) accumulated at 50% on the basis of a volume of a particle size distribution, which means a particle diameter at a point where the particle size distribution is obtained on the basis of the volume and the accumulated value becomes 50% in the cumulative curve with 100% of the total volume. Such a D50 particle size may be measured by a laser diffraction method.

In the present application, the term "spherical shape" means a case where sphericity is about 0.95 or more, and the "rectangular shape" means a case where sphericity is less than 0.95. The sphericity of the particle can be confirmed through a particle shape analysis of the particle. Specifically, the sphericity of the filler, which is a three-dimensional particle, may be defined as a ratio (S'/S) of the surface area (S') of a sphere having the same volume as that of a particle to the surface area (S) of the particle. For real particles, circularity is generally used. The circularity is expressed as a ratio of the boundary of a circle having the same image and the same area (A) as a two-dimensional image of a real particle thus obtained to the boundary (P) of the image, which may be obtained by the following equation. The sphericity in this specification is an average value of circularity measured by Marvern's particle shape analysis equipment (FPIA-3000).

<Circularity Equation>

$$\text{Circularity} = 4\pi A/P^2$$

The circularity is expressed as a value from 0 to 1, where a perfect circle has a value of 1, and as a particle has an irregular shape, it has a value lower than 1.

The composition of the present application comprises a resin component and a filler component, wherein the filler component comprises a filler having a specific gravity of 3 or more and a filler having a specific gravity of less than 3. The content of the filler component in the composition is 80 wt% or more, and the composition forms a cured product having a specific gravity of less than 3.

In the present application, the term scope of resin component may include a resin component by itself or a precursor of the resin component, that is, a component that can become a resin component through a reaction such as a curing reaction or a polymerization reaction.

In one example, the resin component may be a polyol, an isocyanate compound, a urethane resin, an acrylic resin, an epoxy resin, an olefin resin or a silicone resin.

In one example of the present application, when the resin component is a polyol, a polyester polyol may be used. The polyester-based polyol of the present invention may be a polyol having non-crystallinity or sufficiently low crystallinity. In this specification, the "non -crystallinity" means a case where the crystallization temperature (Tc) and melting temperature (Tm) are not observed in a DSC (differential scanning calorimetry) analysis to be described below. The DSC analysis may be performed in the range of -80°C to 60°C at a rate of 10°C/min, which may be performed, for example, in a manner that the temperature is raised from 25°C to 60°C at the rate, and then reduced again to -80°C, and raised again to 60°C. In addition, here, the "sufficiently low crystallinity" means a case where the melting point (Tm) observed in the DSC analysis is less than 15°C, thereby being about 10°C or less, 5°C or less, 0°C or less, -5°C or less, -10°C or less, or about -20°C or less or so. At this time, the lower limit of the melting point is not particularly limited, but, for example, the melting point may be about -80°C or more, -75°C or more, or about - 70°C or more.

In one example, as the polyester-based polyol, for example, a carboxylic acid polyol or a caprolactone polyol may be used.

The carboxylic acid polyol may be formed by reacting a component containing a carboxylic acid and a polyol (e.g., diol or triol, etc.), and the caprolactone polyol may be formed by reacting a component containing caprolactone and a polyol (e.g., diol or triol, etc.). In this case, the carboxylic acid may be a dicarboxylic acid.

In one example, the polyol may be a polyol represented by the following formula 1 or 2.

[Formula 1]

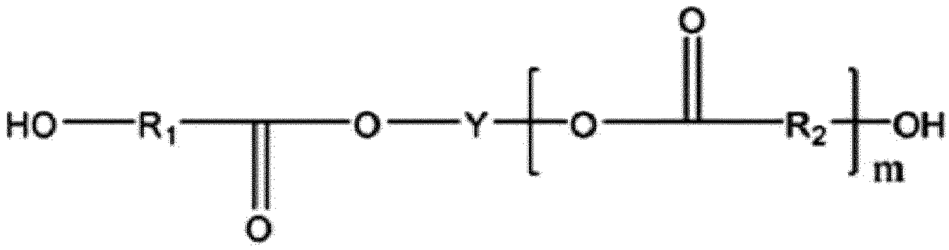

[Formula 2]

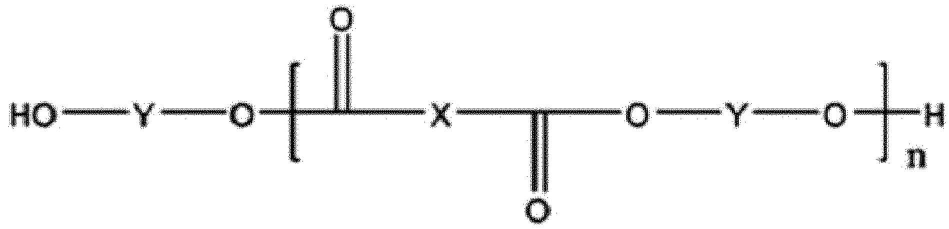

In Formulas 1 and 2, X is a carboxylic acid-derived unit, and Y is a polyol-derived unit. The polyol-derived unit may be, for example, a triol unit or a diol unit. Also, n and m may be any number. For example, n may be a number in the range of 2 to 10 or 2 to 5, and m may be a number in the range of 1 to 10 or 1 to 5. In Formulas 1 and 2, $R_1$ and $R_2$ are each independently an alkylene group, and specific types of the alkylene group are the same as those described in the introduction of Technical Solution in this specification.

That is, when the hydroxy group of the polyol and the carboxyl group of the carboxylic acid react, a water ($H_2O$) molecule is eliminated by the condensation reaction and simultaneously an ester bond is formed. When the carboxylic acid forms the ester bond by the condensation reaction as such, the carboxylic acid-derived unit may mean a portion, which does not participate in the condensation reaction, in the carboxylic acid structure. In addition, the polyol-derived unit may mean a portion, which does not participate in the condensation reaction, in the polyol structure.

Also, Y in Formula 2 also represents a portion excluding the ester bond after the polyol forms the ester bond with caprolactone. That is, when the polyol and the caprolactone form the ester bond, the polyol-derived unit Y in Formula 2 may mean a portion, which does not participate in the ester bond, in the polyol structure. The ester bonds are represented in Formulas 1 and 2, respectively.

Meanwhile, in Formulas above, when the polyol-derived unit of Y is a unit derived from a polyol containing three or more hydroxy groups such as a triol unit, a branched structure may be implemented in the Y portion of the formula structure.

In Formula 1 above, the type of the carboxylic acid-derived unit of X is not particularly limited, but in order to secure the desired physical properties, the unit may be a unit derived from one or more compounds selected from the group consisting of a fatty acid compound, an aromatic compound having two or more carboxyl groups, an alicyclic compound having two or more carboxyl groups and an aliphatic compound having two or more carboxyl groups.

The aromatic compound having two or more carboxyl groups may be, for example, phthalic acid, isophthalic acid, terephthalic acid, trimellitic acid or tetrachlorophthalic acid. The alicyclic compound having two or more carboxyl groups may be, for example, tetrahydrophthalic acid or hexahydrophthalic acid or tetrachlorophthalic acid. In addition, the aliphatic compound having two or more carboxyl groups may be, for example, oxalic acid, adipic acid, azelaic acid, sebacic acid, succinic acid, malic acid, glutaric acid, malonic acid, pimelic acid, suberic acid, 2,2-dimethylsuccinic acid, 3,3-dimethylglutaric acid, 2,2-dimethylglutaric acid, maleic acid, fumaric acid or itaconic acid.

Meanwhile, in Formulas 1 and 2, the type of the polyol-derived unit of Y is not particularly limited, but in order to secure the desired physical properties, the unit may be derived from one or more compounds selected from the group consisting of an alicyclic compound having two or more hydroxy groups and an aliphatic compound having two or more hydroxy groups.

The alicyclic compound having two or more hydroxyl groups may be, for example, 1,3-cyclohexanedimethanol or 1,4-cyclohexanedimethanol. In addition, the aliphatic compound having two or more hydroxyl groups may be, for

example, ethylene glycol, propylene glycol, 1,2-butylene glycol, 2,3-butylene glycol, 1,3-propanediol, 1,3-butanediol, 1,4-butanediol, 1,6-hexanediol, neopentyl glycol, 1,2-ethylhexyldiol, 1,5-pentanediol, 1,9-nonandiol, 1,10-decanediol, glycerin or trimethylolpropane.

In one example of the present application, when the resin component is an isocyanate compound, it may comprise a difunctional isocyanate compound and a polyfunctional isocyanate compound.

The difunctional isocyanate compound means a compound containing two isocyanate groups (-N=C=O) in one molecule, and the polyfunctional isocyanate compound means a compound containing three or more isocyanate groups. In another example, the polyfunctional isocyanate compound may contain 3 to 10, 3 to 9, 3 to 8, 3 to 7, 3 to 6, 3 to 5 or 3 to 4 isocyanate groups.

The difunctional isocyanate compound may have a functional group value according to Equation 1 below in a range of 0.5 to 1.

[Equation 1]

$$\text{Functional group value} = 100 \times N/M$$

In Equation 1, N is the number of isocyanate groups included in the isocyanate compound, and M is the molar mass (unit: g/mol) of the isocyanate compound.

In another example, the functional group value of the difunctional isocyanate compound according to Equation 1 above may be 0.55 or more, 0.6 or more, 0.65 or more, 0.7 or more, 0.75 or more, 0.8 or more, or 0.85 or more, or may be 1 or less, 0.95 or less, or 0.9 or less.

The difunctional isocyanate compound may have a molar mass in a range of 100 to 500 g/mol. In another example, the molar mass may be 110 g/mol or more, 120 g/mol or more, 130 g/mol or more, 140 g/mol or more, 150 g/mol or more, 160 g/mol or more, 170 g/mol or more, 180 g/mol or more, 190 g/mol or more, 200 g/mol or more, 210 g/mol or more, or 220 g/mol or more, or may be 480 g/mol or less, 460 g/mol or less, 440 g/mol or less, 420 g /mol or less, 400 g/mol or less, 380 g/mol or less, 360 g/mol or less, 340 g/mol or less, 320 g/mol or less, 300 g/mol or less, 280 g/mol or less, 260 g/mol or less, 240 g/mol or less, or 230 g/mol or less.

The polyfunctional isocyanate compound may have a functional group value according to Equation 1 below in a range of 0.01 to 0.7.

[Equation 1]

$$\text{Functional group value} = 100 \times N/M$$

In Equation 1, N is the number of isocyanate groups included in the isocyanate compound, and M is the molar mass (unit: g/mol) of the isocyanate compound.

In another example, the functional group value of the polyfunctional isocyanate compound according to Equation 1 may be 0.05 or more, 0.1 or more, 0.15 or more, 0.2 or more, 0.25 or more, 0.3 or more, 0.35 or more, 0.4 or more, 0.45 or more, 0.5 or more, or may be 0.55 or more, 0.68 or less, 0.64 or less, 0.62 or less, or 0.6 or less.

The polyfunctional isocyanate compound may have a molar mass in a range of 300 to 1500 g/mol. In another example, the molar mass may be 320 g/mol or more, 340 g/mol or more, 360 g/mol or more, 380 g/mol or more, 400 g/mol or more, 420 g/mol or more, 440 g/mol or more, 460 g/mol or more, 480 g/mol or more, or 500 g/mol or more, or may be 1500 g/mol or less, 1400 g/mol or less, 1300 g/mol or less, 1200 g/mol or less, 1100 g/mol or less, 1000 g/mol or less, 900 g/mol or less, 800 g/mol or less, 700 g/mol or less, 600 g/mol or less, 550 g/mol or less, or 520 g/mol or less.

At least one or more of an aliphatic difunctional isocyanate compound and an aliphatic cyclic difunctional isocyanate compound may be used as the difunctional isocyanate compound of the present application, but it is preferable to use an aliphatic cyclic difunctional isocyanate compound.

The aliphatic difunctional isocyanate compound may be exemplified by hexamethylene diisocyanate, trimethylhexamethylene diisocyanate, lysine diisocyanate, norbornane diisocyanate, ethylene diisocyanate, propylene diisocyanate and tetramethylene diisocyanate, and the like, but is not particularly limited thereto. The aliphatic cyclic difunctional isocyanate compound may be exemplified by transcyclohexane-1,4-diisocyanate, isophorone diisocyanate, bis(isocyanatemethyl)cyclohexane diisocyanate and dicyclohexylmethane diisocyanate, and the like, but is not particularly limited thereto. In addition, one or two or more of the difunctional isocyanate compounds may be used.

As the polyfunctional isocyanate compound according to the present application, for example, a multimer above a trimer of the isocyanate compound may be used, and a compound in the form of a biuret which can be obtained by reacting the isocyanate compound with water may also be used. That is, one or more selected from a multimer of an

isocyanate compound and a biuret compound may be used as the polyfunctional isocyanate compound.

Specifically, a multimer such as hexamethylene diisocyanate, trimethylhexamethylene diisocyanate, lysine diisocyanate, norbornane diisocyanate, ethylene diisocyanate, propylene diisocyanate, tetramethylene diisocyanate, transcyclohexane-1,4-diisocyanate, isophorone diisocyanate, bis(isocyanate methyl) cyclohexane diisocyanate and dicyclohexylmethane diisocyanate, and a compound in the form of a biuret may be included as an example of a polyfunctional isocyanate compound.

According to one example of the present application, the polyfunctional isocyanate compound may be a trifunctional isocyanate compound containing three isocyanate groups. The trifunctional isocyanate compound may be a compound represented by Formula 3 below.

[Formula 3]

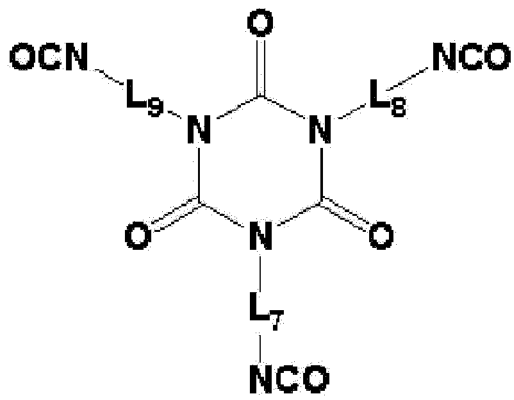

In Formula 3, $L_7$, $L_8$ and $L_9$ may be each independently an alkylene group, an alkenylene group or an alkynyl group. Specific types of the alkylene group, alkenylene group, or alkynyl group in the definition of Formula 3 above are the same as those described in the introduction of Technical Solution in this specification.

When the resin component is an isocyanate compound including a difunctional isocyanate compound and a polyfunctional isocyanate compound, the content of the polyfunctional isocyanate compound may be, in the entire isocyanate compound, 30 wt% or more, 35 wt% or more, 40 wt% or more, 45 wt% or more, 50 wt% or more, 55 wt% or more, or 60 wt% or more, or may be 85 wt% or less, 80 wt% or less, 75 wt% or less, 70 wt% or less, or 65 wt% or less.

In addition, the content of the diisocyanate compound may be, in the entire isocyanate compound, 20 parts by weight or more, 25 parts by weight or more, 30 parts by weight or more, 35 parts by weight or more, 40 parts by weight or more, 45 parts by weight or more, 50 parts by weight or more, or 55 parts by weight or more, or may be 95 parts by weight or less, 90 parts by weight or less, 85 parts by weight or less, 80 parts by weight or less, 75 parts by weight or less, 70 parts by weight or less, or 65 parts by weight or less.

The filler component included in the composition of the present application is a thermally conductive filler, which may secure heat dissipation or thermal conductivity of the composition or a cured product of the composition. In the present application, the filler component may comprise a thermally conductive filler having a specific gravity of 3 or more and a thermally conductive filler having a specific gravity of less than 3.

The thermally conductive filler component that can be used in the present application may be oxides such as alumina (aluminum oxide), magnesium oxide, beryllium oxide or titanium oxide; nitrides such as boron nitride, silicon nitride or aluminum nitride; carbides such as silicon carbide; hydrated metals such as aluminum hydroxide or magnesium hydroxide; metal filling materials such as copper, silver, iron, aluminum or nickel; metal alloy filling materials such as titanium; or silicon powders such as quartz, glass or silica, but is not limited thereto. Furthermore, if insulating properties may be secured, the application of a carbon filler such as graphite may also be considered. For example, the carbon filler may utilize activated carbon, but is not limited thereto.

The present application may appropriately select and use, in the above-described thermally conductive filler, a thermally conductive filler having a specific gravity of 3 or more and a thermally conductive filler having a specific gravity of less than 3. Also, if the cured product of the composition may be formed to have a specific gravity of less than 3 by appropriately mixing the thermally conductive filler having a specific gravity of 3 or more and a thermally conductive filler having a specific gravity of less than 3 in the above-described thermally conductive fillers, the type of the specific filler which can be selected and used is not limited.

An excess of filler may be included in the composition of the present application. In one example, the composition of the present application may comprise a filler component in an amount of 80 wt% or more in order to secure desired

physical properties (e.g., thermal conductivity). In another example, the filler component may be included in the composition in an amount of 82 wt% or more, 85 wt% or more, 87 wt% or more, or 90 wt% or more, and may be included in an amount of 95 wt% or less, 94 wt% or less, 93 wt% or less, 92 wt% or less, or 90 wt% or less.

When an excessive amount of filler is included, the specific gravity of the cured product of the composition increases and thus it is difficult to realize weight reduction of the product, so that it is required to lower the specific gravity of the cured product while comprising an excess of filler. In addition, even if desired physical properties (e.g., thermal conductivity) are secured, it is required that the temporal change of the physical properties does not occur over time in order to secure storage stability and processability.

In one example, the filler component of the present application may comprise 60 wt% or more of the filler having a specific gravity of 3 or more. In another example, the filler having a specific gravity of 3 or more may be included in an amount of 62 wt% or more, 64 wt% or more, 66 wt% or more, 68 wt% or more, 70 wt% or more, 72 wt% or more, 74 wt% or more, 76 wt% or more, 78 wt% or more, or 80 wt% or more. The upper limit of the content of the filler component having a specific gravity of 3 or more may be, for example, 90 wt% or less, 89 wt% or less, 88 wt% or less, 87 wt% or less, 86 wt% or less, 85 wt% or less, 84 wt% or less, 83 wt% or less, 82 wt% or less, 81 wt% or less, or 80 wt% or less. When the filler having a specific gravity of 3 or more is included in the above range, it is possible to provide a composition which achieves a low specific gravity effect in a state where a filler is filled in a high content and in a state where realization of physical properties by filling of the filler is sufficiently secured, and has improved storage stability without deterioration of physical properties such as a thermal conductivity.

In one example, the filler having a specific gravity of less than 3 in the filler component may be included in an amount of 10 to 65 parts by weight relative to 100 parts by weight of the filler having a specific gravity of 3 or more. In another example, the filler having a specific gravity of less than 3 may be included in an amount of 13 parts by weight or more, 15 parts by weight or more, 18 parts by weight or more, 21 parts by weight or more, 24 parts by weight or more, 27 parts by weight or more, 30 parts by weight or more, or 33 parts by weight or more, or may be included in an amount of 62 parts by weight or less, 59 parts by weight or less, 56 parts by weight or less, 54 parts by weight or less, 50 parts by weight or less, 48 parts by weight or less, 46 parts by weight or less, 43 parts by weight or less, 40 parts by weight or less, 37 parts by weight or less, or 34 parts by weight or less, relative to 100 parts by weight of the filler having a specific gravity of 3 or more. When the filler having a specific gravity of less than 3 is included in the above range relative to 100 parts by weight of the filler having a specific gravity of 3 or more, it is possible to provide a composition which achieves a low specific gravity effect in a state where a filler is filled in a high content and in a state where realization of physical properties by filling of the filler is sufficiently secured, and has improved storage stability without deterioration of physical properties such as a thermal conductivity.

In the present application, the filler having a specific gravity of less than 3 may have a D50 particle size of 50 to 90μm. In another example, the D50 particle size of the filler having a specific gravity of less than 3 may be 51μm or more, 52μm or more, 53μm or more, 54μm or more, 55μm or more, 56μm or more, 57μm or more, 58μm or more, 59μm or more, or 60μm or more, or may be 85μm or less, 80μm or less, 75μm or less, 70μm or less, 65μm or less, or 60μm or less.

In one example, the ratio of the filler having a specific gravity of less than 3 in the filler component may be 10 to 50 wt%. In another example, the ratio of the filler having a specific gravity of less than 3 may be 11 wt% or more, 12 wt% or more, 13 wt% or more, 14 wt% or more, 15 wt% or more, 16 wt% or more, 18 wt% or more, or 20 wt% or more, or may be 47 wt% or less, 45 wt% or less, 43 wt% or less, 40 wt% or less, 37 wt% or less, 35 wt% or less, 33 wt% or less, 30 wt% or less, 28 wt% or less, 26 wt% or less, 24 wt% or less, 22 wt% or less, or 20 wt% or less. If the ratio of the filler having a specific gravity of less than 3 in the filler component is less than 10 wt%, there is a problem in that the specific gravity of the cured product increases, and if it exceeds 50 wt%, the temporal change phenomenon in the physical properties (e.g., thermal conductivity) of the cured product may occur, it is preferably included within the above-described range. When the filler having a specific gravity of less than 3 is included in the above range, it is possible to provide a composition which achieves a low specific gravity effect in a state where a filler is filled in a high content and in a state where realization of physical properties by filling of the filler is sufficiently secured, and has improved storage stability without deterioration of physical properties such as a thermal conductivity.

In one example, the filler component of the present application may comprise a first filler having a specific gravity of 3 or more and a D50 particle size in a range of 50 to 200μm, and a second filler having a specific gravity of 3 or more and a D50 particle size in a range of 0.5 to 5μm.

In one example, the D50 particle size of the first filler may be 55 μm or more, 60 μm or more, 65 μm or more, or 70 μm or more, or may be 195 μm or less, 190 μm or less, 185 μm or less, 180 μm or less, 175 μm or less, 170 μm or less, 165 μm or less, 160 μm or less, 155 μm or less, 150 μm or less, 145 μm or less, 140 μm or less, 135 μm or less, 130 μm or less, 125 μm or less, about 120 μm or less, 115 μm or less, 110 μm or less, 105 μm or less, 100 μm or less, 95 μm or less, 90 μm or less, 85 μm or less, 80 μm or less, or about 75 μm or less.

Also, in one example, the D50 particle size of the second filler may be 0.01 μm or more, 0.1 μm or more, about 0.5 μm or more, 1 μm or more, 1.5 μm or more, or 2 μm or more, or may be 5 μm or less, 4.5 μm or less, about 4 μm

or less, 3.5 μm or less, 3 μm or less, 2.5 μm or less, or 2 μm or less.

In one example, the first filler may be included in an amount of 25 to 50 wt% in the filler component. In another example, the first filler may be included in an amount of 28 wt% or more, 30 wt% or more, 33 wt% or more, or 35 wt% or more, or may be included in an amount of 48 wt% or less, 46 wt% or less, 44 wt% or less, 42 wt% or less, 40 wt% or less, 38 wt% or less, or 35 wt% or less, in the filler component.

In one example, the second filler may be included in an amount of 10 to 50 wt% in the filler component. In another example, the second filler may be included in an amount of 13 wt% or more, 15 wt% or more, 17 wt% or more, 20 wt% or more, 22 wt% or more, 25 wt% or more, 28 wt% or more, or 30 wt% or more, or may be included in an amount of 48 wt% or less, 46 wt% or less, 44 wt% or less, 42 wt% or less, 40 wt% or less, 38 wt% or less, 35 wt% or less, 33 wt% or less, or 30 wt% or less, in the filler component.

The filler component of the present application may further comprise a third filler having a specific gravity of 3 or more and a D50 particle size in a range of 10 to 30 μm. In another example, the D50 particle size of the third filler may be 12 μm or more, 13 μm or more, 14 μm or more, 15 μm or more, 16 μm or more, 17 μm or more, 18 μm or more, 19 μm or more, or 20 μm or more, or may be about 29 μm or less, 28 μm or less, 27 μm or less, 26 μm or less, 25 μm or less, 24 μm or less, 23 μm or less, 22 μm or less, 21 μm or less, or 20 μm or less.

The weight ratio (C3/C2) of the third filler (C3) to the second filler (C2) may be 1 or less. Specifically, the weight ratio (C2/C3) may be 0.9 or less, 0.8 or less, 0.7 or less, 0.6 or less, 0.5 or less, or 0.4 or less, or may be 0 or more, 0.1 or more, 0.2 or more, or 0.3 or more.

The shape of the filler component as described above may be used by appropriately selecting a spherical and/or rectangular shape (e.g., needle-shape and plate-shape, etc.) as needed, but is not limited thereto. Considering the amount to be filled, it is advantageous to use a spherical filler, but a rectangular filler such as a needle-shaped or plate-shaped filler may also be used in consideration of network formation or conductivity, and the like.

For example, the filler having a specific gravity of 3 or more and the filler having a specific gravity of less than 3 may have different shapes, respectively, and the first, second and third fillers having the same specific gravity may have different shapes, respectively. Also, in another example, each of the first filler, the second filler and the third filler having the same specific gravity and the same particle size may be configured by mixing spherical and/or rectangular fillers, but in consideration of the cost reduction effect, it is preferable to use a rectangular filler as the second filler.

The composition of the present application may be a one-component resin composition, a main composition or a curing agent composition of a two-component resin composition, or a mixture of a main composition and a curing agent composition of a two-component resin composition. The one-component resin composition is a resin composition in which the curable components are stored in a mixed state, and the two-component resin composition is a resin composition in which the curable components are physically separated into a main composition and a curing agent composition and stored separately. In the case of the two-component resin composition, the main composition and the curing agent composition are mixed under conditions in which curing can occur at the time of use.

When the composition of the present application is the mixture of the main composition and the curing agent composition of the two-component resin composition, the ratio (V1/V2) of the volume of the main composition (V1) to the volume (V2) of the curing agent composition may be in the range of 0.5 to 1.5 or in the range of 0.75 to 1.25.

The composition of the present application basically comprises the above components, that is, the resin component and the filler component, which may also comprise other components if necessary.

In one example, the curing reaction of the composition comprising the main resin and the curing agent resin may be assisted by a catalyst. As the catalyst, for example, a tin-based catalyst may be used. As one example of the tin-based catalyst, dibutyltin dilaurate (DBTDL) may be used.

The composition of the present application may further comprise a thiol compound. The thiol compound may be included in the composition to serve as a curing retardant to control the curing rate so that the composition of the present application is suitable for use. In particular, by appropriately adjusting the contents of the catalyst and the thiol compound, the composition of the present application has an advantage that the composition can be adjusted to have an appropriate curing rate in terms of workability.

In one example of the present application, the thiol compound is a compound containing one thiol group, which may be represented by the following formula 4.

[Formula 4]

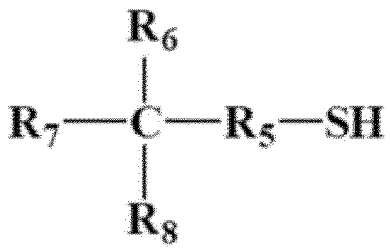

In Formula 4, $R_5$ is a single bond, an alkylene group, an alkenylene group or an alkynylene group, and $R_6$, $R_7$ and $R_8$ may be each independently hydrogen, an alkyl group, an alkenyl group or an alkynyl group.

Specific types of the alkylene group, alkenylene group or alkynylene group in the definition of Formula 4 above are the same as those described in the introduction of Technical Solution of this specification.

In one example, the thiol compound may be exemplified by ethanethiol, propanethiol, butanethiol, pentanethiol, hexanethiol, heptanethiol, octanethiol, 2-ethylhexanethiol, nonanethiol, decanethiol, 2-propylheptanethiol, ethenethiol, propenethiol, butenethiol, acetylenethiol, propynethiol, butynthiol, benzenethiol, methylbenzenethiol, pyridinethiol and methylpyridinethiol, and the like, but is not particularly limited, as long as it contains one thiol group. In addition, as the thiol compound, one or two or more of the above-mentioned may be used.

The composition may comprise a viscosity modifier for control of the viscosity, for example, for increasing or decreasing the viscosity, or for control of the viscosity according to shear force. In addition, for example, it may further comprise a thixotropic agent, a diluent, a dispersant or a coupling agent, and the like.

The thixotropic agent adjusts the viscosity of the composition according to the shear force, whereby the manufacturing process of the battery module allows to be effectively performed. As the usable thixotropic agent, fumed silica and the like may be exemplified.

The diluent or dispersant is generally used to lower the viscosity of the composition, and as long as it can exhibit such an action, various types known in the art can be used.

In the case of the coupling agent, for example, it can be used to improve the dispersibility of the filler, and as long as it can exhibit such an action, various types of known in the art can be used without limitation.

The composition may further comprise a flame retardant or a flame retardant adjuvant, and the like. As the flame retardant, various known flame retardants may be applied without particular limitation, and for example, a flame retardant in the form of a solid filler or a liquid flame retardant, and the like may be applied. The flame retardant includes, for example, an organic flame retardant such as melamine cyanurate or an inorganic flame retardant such as magnesium hydroxide, but is not limited thereto. If the amount of filler to be filled is excessive, a liquid type flame retardant material (TEP, triethyl phosphate or TCPP, tris(1,3-chloro-2-propyl)phosphate, etc.) may also be used. In addition, a silane coupling agent capable of serving as a flame retardant synergist may also be added.

In addition, the composition may comprise a hygroscopic agent. When the hygroscopic agent is included, storage stability may be ensured, and problems such as surface hardening or viscosity increase of the composition due to moisture may be solved. The hygroscopic agent may be, for example, methyldiphenylethoxysilane, molecular sieves, p-toluenesulfonyl isocyanate (PTSI), Tosyl isocyanate (TI), for example, acid anhydride esters such as diethyl malonate and dimethyl succinate, (unsaturated) silane compounds represented by the following formula, and a mixture of the foregoing.

The composition of the present application may be cured to form a cured product, which may satisfy the following physical properties.

In the composition of the present application, the cured product after curing may have a specific gravity of less than 3. The specific gravity may be, for example, 2.95 or less, 2.9 or less, 2.85 or less, 2.8 or less, 2.75 or less, or 2.7 or less, but is not limited thereto. As the specific gravity of the cured product of the composition of the present application has the lower value, it is advantageous in reducing the weight of the applied product, so that the lower limit of the specific gravity is not particularly limited, but it may be, for example, 0.5 or more, 1 or more, 1.5 or more, 2 or more, 2.3 or more, or 2.5 or more. The cured product of the composition of the present application has a low specific gravity characteristic as in the above range, whereby a weight reduction effect of the product to which the composition is applied can be expected. The specific gravity may be a numerical value measured according to a specific gravity measuring method to be described below.

The composition of the present application may form a cured product having a thermal conductivity of 3W/m·K or more. Specifically, the thermal conductivity may be 3.1 W/m·K or more, 3.2 W/m·K or more, 3.3 W/m·K or more, or

3.4 W/m·K or more, and may be 50 W/m·K or less, 45 W/m K or less, 40 W/m K or less, 35 W/m K or less, 30 W/m K or less, 25 W/m K or less, 20 W/m K or less, 15 W/ m K or less, 10 W/m K or less, 5 W/m·K or less, 4.5 W/m·K or less, about 4.0 W/m K or less, or 3.5 W/m·K or less. In a state where the composition is prepared as a sample with a thickness of 5mm, the thermal conductivity may be a value measured according to ASTM D5470 standard or ISO 22007-2 standard along the thickness direction of the sample.

In addition, the cured product of the composition of the present application may have a thermal conductivity change rate of 0.99 or more according to Equation 2 below. Specifically, the cured product of the composition of the present application may have a thermal conductivity change rate of 1 or more, 1.01 or more, 1.02 or more, 1.03 or more, 1.04 or more, or 1.05 or more, according to Equation 2 below. The upper limit of the thermal conductivity change rate is not limited, but may be, for example, 3 or less, 2.5 or less, 2 or less, 1.5 or less, 1.3 or less, 1.1 or less, 1.08 or less, or 1.06 or less.

[Equation 2]

$$\text{Thermal conductivity change rate} = Tc2/Tc1$$

In Equation 2 above, Tc1 is the thermal conductivity measured after leaving the composition at room temperature (25°C) for 1 hour, and Tc2 is the thermal conductivity measured after leaving the composition at room temperature for 10 days.

As described above, the cured product of the composition of the present application can realize low specific gravity properties of less than 3, and has excellent heat dissipation performance by satisfying thermal conductivity of 3W/m·K or more, and an effect of improved storage stability because physical properties such as thermal conductivity are not reduced over time.

The present application also relates to a product comprising a heating element and the composition or a cured product thereof in thermal contact with the heating element. The contents of the composition or a cured product thereof as described above may be equally applied to the composition or a cured product thereof.

Products comprising the composition of the present application and its cured product may include various electric products and electronic products such as irons, washing machines, dryers, clothes conditioners, electric shavers, microwaves, electric ovens, electric rice cookers, refrigerators, dishwashers, air conditioners, electric fans, humidifiers, air purifiers, mobile phones, walkie-talkies, televisions, radios, computers and laptops, or batteries such as secondary batteries, and the like. Particularly, in an electric car battery manufactured by combining battery cells to form one battery module and combining multiple battery modules to form one battery pack, the composition according to one example of the present application may be used as a material for connecting the battery modules. When the composition according to one example of the present application is used as the material for connecting the battery modules, it may play a role in dissipating heat emitted from the battery cells and fixing the battery cells from external shock and vibration.

The composition of the present application and a cured product thereof may transfer heat generated from the heating element of the electric products and electronic products or the batteries as described above, and the like to a cooling region. That is, the composition of the present application and a cured product thereof may radiate heat generated from the heating element.

The composition and a cured product thereof may be placed between the heating element and the cooling region to thermally contact them. The thermal contact means that the cured product of the composition is in direct physical contact with the heating element and cooling region to dissipate heat generated from the heating element to the cooling region, or even if the cured product does not directly contact the heating element and/or cooling region (that is, a separate layer exists between the cured product of the composition and the heating element and/or the cooling region), the heat generated by the heating element is dissipated to the cooling region. That is, the composition of the present application and a cured product thereof may dissipate heat in electric products and electronic products or batteries, and provide durability against impact, insulation, and the like.

[Effects of Invention]

According to the present invention, it is possible to provide a composition which achieves a low specific gravity effect in a state where a filler is filled in a high content and in a state where realization of physical properties by filling of the filler is sufficiently secured, and has improved storage stability without deterioration of physical properties such as a thermal conductivity.

[Mode for Invention]

Hereinafter, the present application will be described in detail through Examples, but the scope of the present application is not limited by Examples below.

**Example 1**

Spherical alumina (C1a) with a D50 particle size of 70μm, spherical alumina (C3a) with a D50 particle size of 20μm, rectangular alumina (C2) with a D50 particle size of 2μm, and rectangular aluminum hydroxide (AH) with a D50 particle size of 60μm were mixed in a weight ratio of 40:20:20:20 (C1a: C3a: C2: AH), respectively, to prepare a filler component. The specific gravity of alumina used is 3.965, and the specific gravity of aluminum hydroxide is 2.423.

The D50 particle size of the filler as mentioned herein is a particle diameter (median diameter) accumulated at 50% in a cumulative curve on the basis of a volume of a particle size distribution. Such a particle size can be defined as a particle diameter at a point where the particle size distribution is obtained on the basis of the volume and the accumulated value becomes 50% in the cumulative curve with 100% of the total volume. The D50 particle size could be measured using Marven's MASTERSIZER 3000 equipment in accordance with ISO-13320, where ethanol was used as the solvent.

The prepared filler component was mixed with a polyol and other additives (curing retardant, dispersant, flame retardant) in a weight ratio of 90:8:2 (filler component: polyol: additives), and the mixture was mixed and dispersed at 600 rpm in revolution and 500 rpm in rotation for 3 minutes or so with a paste mixer and then the generated heat was confirmed, and defoamed in a vacuum state at 600 rpm in revolution and 200 rpm in rotation for 4 minutes, thereby preparing a main composition.

The polyol was a caprolactone polyol, in which one obtained by reacting 1,4-butanediol and caprolactone in a weight ratio of 1:2.79 (1,4-butanediol: caprolactone) was used.

In addition, the prepared filler component was mixed with an isocyanate mixture and other additives (hygroscopic agent, dispersant, flame retardant) in a weight ratio of 90:8:2 (filler component: isocyanate mixture: additives), and the mixture was mixed and dispersed at 600 rpm in revolution and 500 rpm in rotation for 3 minutes or so with a paste mixer and then the generated heat was confirmed, and defoamed in a vacuum state at 600 rpm in revolution and 200 rpm in rotation for 4 minutes, thereby preparing a curing agent composition.

As the isocyanate mixture, one obtained by mixing hexamethylene diisocyanate trimer (number of isocyanate groups: 3, molar mass: about 504.6 g/mol) and isophorone diisocyanate (number of isocyanate groups: 2, molar mass: about 222.3 g/mol) was used. The functional group value of hexamethylene diisocyanate trimer calculated by the following equation 1 is 0.59, and the functional group value of isophorone diisocyanate is 0.89.

[Equation 1]

$$\text{Functional group value} = 100 \times N/M$$

In Equation 1, N is the number of isocyanate groups included in the isocyanate compound, and M is the molar mass (unit: g/mol) of the isocyanate compound.

The main composition and the curing agent composition as prepared were mixed in a volume ratio of 1:1 to prepare a composition.

**Example 2**

A composition was prepared as in the same method as in Example 1 above, except that spherical alumina (C1a) with a D50 particle size of 70μm, spherical alumina (C3a) with a D50 particle size of 20μm, rectangular alumina (C2) with a D50 particle size of 2μm, and rectangular aluminum hydroxide (AH) with a D50 particle size of 60μm were mixed in a weight ratio of 35:20:20:25 (C1a: C3a: C2: AH), respectively, to prepare a filler.

**Example 3**

A composition was prepared as in the same method as in Example 1 above, except that spherical alumina (C1a) with a D50 particle size of 70μm, rectangular alumina (C2) with a D50 particle size of 2μm, and rectangular aluminum hydroxide (AH) with a D50 particle size of 60μm were mixed in a weight ratio of 30:40:30 (C1a: C2: AH), respectively, to prepare a filler.

**Example 4**

A composition was prepared as in the same method as in Example 1 above, except that spherical alumina (C1a) with a D50 particle size of 70μm, rectangular alumina (C2) with a D50 particle size of 2μm, and rectangular aluminum hydroxide (AH) with a D50 particle size of 60μm were mixed in a weight ratio of 35:30:35 (C1a: C2: AH), respectively, to prepare a filler.

**Example 5**

A composition was prepared as in the same method as in Example 1 above, except that spherical alumina (C1a) with a D50 particle size of 70μm, rectangular alumina (C3b) with a D50 particle size of 20μm, rectangular alumina (C2) with a D50 particle size of 2μm, and rectangular aluminum hydroxide (AH) with a D50 particle size of 60μm were mixed in a weight ratio of 40:20:20:20 (C1a: C3b: C2: AH), respectively, to prepare a filler.

**Example 6**

A composition was prepared as in the same method as in Example 1 above, except that spherical alumina (C1a) with a D50 particle size of 70μm, rectangular alumina (C1b) with a D50 particle size of 70μm, rectangular alumina (C3b) with a D50 particle size of 20μm, rectangular alumina (C2) with a D50 particle size of 2μm, and rectangular aluminum hydroxide (AH) with a D50 particle size of 60μm were mixed in a weight ratio of 20:20:20:20:20 (C1a: C1b: C3b: C2: AH), respectively, to prepare a filler.

**Example 7**

A composition was prepared as in the same method as in Example 1 above, except that spherical alumina (C1a) with a D50 particle size of 70μm, spherical alumina (C3a) with a D50 particle size of 20μm, rectangular alumina (C2) with a D50 particle size of 2μm, and rectangular aluminum hydroxide (AH) with a D50 particle size of 60μm were mixed in a weight ratio of 40: 10:30:20 (C1a: C3a: C2: AH), respectively, to prepare a filler.

**Comparative Example 1**

A composition was prepared as in the same method as in Example 1 above, except that aluminum hydroxide was not used, and spherical alumina (C1a) having a D50 particle size of 70μm, spherical alumina (C3a) with a D50 particle size of 20μm, and rectangular alumina (C2) with a D50 particle size of 2μm were mixed in a weight ratio of 60:20:20 (C1a: C3a: C2), respectively, to prepare a filler.

**Comparative Example 2**

A composition was prepared as in the same method as in Example 1 above, except that aluminum hydroxide was not used, and spherical alumina (C1a) having a D50 particle size of 70μm, rectangular alumina (C3b) with a D50 particle size of 20μm, and rectangular alumina (C2) with a D50 particle size of 2μm were mixed in a weight ratio of 60:20:20 (C1a: C3b: C2), respectively, to prepare a filler.

**Comparative Example 3**

A composition was prepared as in the same method as in Example 1 above, except that aluminum hydroxide was not used, and spherical alumina (C1a) with a D50 particle size of 70μm, rectangular alumina (C1b) with a D50 particle size of 70μm, spherical alumina (C3a) with a D50 particle size of 20μm, and rectangular alumina (C2) with a D50 particle size of 2μm rectangular alumina were mixed in a weight ratio of 40:20:20:20 (C1a: C1b: C3a: C2), respectively, to prepare a filler.

**Comparative Example 4**

A composition was prepared as in the same method as in Example 1 above, except that aluminum hydroxide was not used, and spherical alumina (C1a) with a D50 particle size of 70μm, rectangular alumina (C1b) with a D50 particle size of 70μm, rectangular alumina (C3b) with a D50 particle size of 20μm, and rectangular alumina (C2) with a D50 particle size of 2μm were mixed in a weight ratio of 40:20:20:20 (C1a: C1b: C3b: C2), respectively, to prepare a filler.

**Comparative Example 5**

A composition was prepared as in the same method as in Example 1 above, except that aluminum hydroxide was not used, and spherical alumina (C1a) with a D50 particle size of 70μm, spherical alumina (C3a) with a D50 particle size of 20μm, and rectangular alumina (C2) with a D50 particle size of 2μm were mixed in a weight ratio of 40:30:30 (C1a: C3a: C2), respectively, to prepare a filler.

**Experimental Example 1. Measurement of thermal conductivity and measurement of thermal conductivity change degree**

The thermal conductivities of the cured products of the compositions of Examples 1 to 7 and the compositions of Comparative Examples 1 to 5 were compared. The compositions were each left at 25°C for 1 hour to prepare a cured product.

The thermal conductivity of the cured product of the composition was measured by a hot disk method according to ISO 22007-2 standard. Specifically, the thermal conductivity measurement may be performed by placing the composition in a mold having a thickness of about 5mm or so, and measuring the thermal conductivity in the thickness direction (through plane direction) using a Hot Disk device. As stipulated in the above standard, the Hot Disk device is a device that can identify the thermal conductivity by measuring the temperature change (electrical resistance change) while the sensor with a nickel wire of a double spiral structure is heated, and the thermal conductivity was measured according to such a standard.

Thereafter, the thermal conductivity change degrees of the cured products of the compositions of Examples 1 to 7 and Comparative Examples 1 to 5 were compared. Specifically, the thermal conductivity of the cured product left at room temperature for 1 hour, the thermal conductivity of the cured product left at room temperature for 5 days, and the thermal conductivity of the cured product left at room temperature for 10 days were compared, whereby the thermal conductivity change degrees were compared. The thermal conductivities after 5 days and 10 days were measured by the same method as the method for measuring a thermal conductivity as described above. The thermal conductivity change rate of the cured product left at room temperature for 10 days compared to the thermal conductivity of the cured product left at room temperature for 1 hour was calculated according to Equation 2 below.

[Equation 2]

$$\text{Thermal conductivity change rate} = Tc2/Tc1$$

In Equation 2 above, Tc1 is the thermal conductivity measured after leaving the composition at room temperature (25°C) for 1 hour, and Tc2 is the thermal conductivity measured after leaving the composition at room temperature for 10 days.

The thermal conductivities of the cured products in which the compositions of Examples 1 to 7 and Comparative Examples 1 to 5 were left at room temperature for 1 hour, the thermal conductivities of the cured products left at room temperature for 5 days, the thermal conductivities of the cured products left at room temperature for 10 days, and the thermal conductivity change rates (Tc2/Tc1) were summarized in Table 1 below.

[Table 1]

| | | First filler (C1) | | Third filler (C3) | | Second filler (C2) (wt%) | Aluminum hydroxide (AH) (wt%) | Thermal conductivity after 1 hours (Tc1) (W/m·K) | Thermal conductivity after 5 days (W/m·K) | Thermal conductivity after 10 days (W/m·K) | Thermal conductivity change rate (Tc2/Tc1) (W/m·K) |
|---|---|---|---|---|---|---|---|---|---|---|---|
| | | Spherical (C1a) (wt%) | Rectangular (C1b) (wt%) | Spherical (C3a) (wt%) | Rectangular (C3b) (wt%) | | | | | | |
| Example | 1 | 40 | - | 20 | - | 20 | 20 | 318 | 3.22 | 3.23 | 1.02 |
| | 2 | 35 | - | 20 | - | 20 | 25 | 300 | 3.01 | 3.10 | 1.03 |
| | 3 | 30 | - | - | - | 40 | 30 | 3.09 | 3.05 | 3.11 | 1.01 |
| | 4 | 35 | - | - | - | 30 | 35 | 3.03 | 3.05 | 3.05 | 1.01 |
| | 5 | 40 | - | - | 20 | 20 | 20 | 3.28 | 3.53 | 3.45 | 1.05 |
| | 6 | 20 | 20 | - | 20 | 20 | 20 | 3.44 | 3.40 | 3.42 | 0.99 |
| | 7 | 40 | - | 10 | - | 30 | 20 | 309 | 303 | 309 | 1 |
| Comparative Example | 1 | 60 | - | 20 | - | 20 | - | 3.07 | 3.09 | 3.02 | 0.98 |
| | 2 | 60 | - | - | 20 | 20 | - | 3.15 | 3.19 | 307 | 0.97 |
| | 3 | 40 | 20 | 20 | - | 20 | - | 3.47 | 3.54 | 3.40 | 0.98 |
| | 4 | 40 | 20 | - | 20 | 20 | - | 3.26 | 3.53 | 3.45 | 1.06 |
| | 5 | 40 | - | 30 | - | 30 | - | 3.10 | 3.12 | 309 | 1 |

**Experimental Example 2. Measurement of specific gravity**

The specific gravities of the cured products of the compositions of Examples 1 to 7 and the cured products of the compositions of Comparative Examples 1 to 5 were compared.

The specific gravity was measured according to ASTM D1475 standard. For example, after the cured product is weighed and then weighed again in water, according to the above standard, the density and specific gravity may be calculated through the difference between the measured weights, or a predetermined amount (about 5 g) of powders or pellets is put into the already-measured volume in a pyrometer and the specific gravity may be calculated through the difference between the weight and the volume at 25°C.

The specific gravities of the cured products of the compositions of Examples 1 to 7 and the cured products of the compositions of Comparative Examples 1 to 5 were summarized in Table 2 below.

[Table 2]

| | | First filler (C1) | | Third filler (C3) | | Second filler (C2) (wt%) | Aluminum hydroxide (AH) (wt%) | Specific gravity |
|---|---|---|---|---|---|---|---|---|
| | | Spherical (C1a) (wt%) | Rectangular (C1b) (wt%) | Spherical (C3a) (wt%) | Rectangular (C3b) (wt%) | | | |
| Example | 1 | 40 | - | 20 | - | 20 | 20 | 2.9 |
| | 2 | 35 | - | 20 | - | 20 | 25 | 2.8 |
| | 3 | 30 | - | - | - | 40 | 30 | 2.8 |
| | 4 | 35 | - | - | - | 30 | 35 | 2.7 |
| | 5 | 40 | - | - | 20 | 20 | 20 | 2.9 |
| | 6 | 20 | 20 | - | 20 | 20 | 20 | 2.9 |
| | 7 | 40 | - | 10 | - | 30 | 20 | 2.9 |
| Comparative Example | 1 | 60 | - | 20 | - | 20 | - | 3.0 |
| | 2 | 60 | - | - | 20 | 20 | - | 3.1 |
| | 3 | 40 | 20 | 20 | - | 20 | - | 3.3 |
| | 4 | 40 | 20 | - | 20 | 20 | - | 3.3 |
| | 5 | 40 | - | 30 | - | 30 | - | 3.0 |

## Claims

1. A composition comprising:

   a resin component; and a filler component, wherein
   the filler component comprises a filler having a specific gravity of 3 or more and a filler having a specific gravity of less than 3, and
   the content of the filler component is 80 wt% or more, and
   the composition forms a cured product having a specific gravity of less than 3.

2. The composition according to claim 1, wherein the resin component is a polyol, an isocyanate compound, a urethane resin, an acrylic resin, an epoxy resin, an olefin resin or a silicone resin.

3. The composition according to claim 1, wherein the resin component comprises a difunctional isocyanate compound and a polyfunctional isocyanate compound.

4. The composition according to claim 3, wherein the difunctional isocyanate compound has a functional group value according to the following equation 1 in a range of 0.5 to 1:

[Equation 1]

$$\text{Functional group value} = 100 \times N/M$$

wherein, N is a number of isocyanate groups included in the isocyanate compound, and M is a molar mass (unit: g/mol) of the isocyanate compound.

**5.** The composition according to claim 3, wherein the difunctional isocyanate compound has a molar mass in a range of 100 to 500 g/mol.

**6.** The composition according to claim 3, wherein the difunctional isocyanate compound is an aliphatic cyclic isocyanate compound.

**7.** The composition according to claim 3, wherein the polyfunctional isocyanate compound has a functional group value according to the following equation 1 in a range of 0.01 to 0.7:

[Equation 1]

$$\text{Functional group value} = 100 \times N/M$$

wherein, N is a number of isocyanate groups included in the isocyanate compound, and M is a molar mass (unit: g/mol) of the isocyanate compound.

**8.** The composition according to claim 3, wherein the polyfunctional isocyanate compound has a molar mass in a range of 300 to 1500 g/mol.

**9.** The composition according to claim 3, wherein the polyfunctional isocyanate compound is a compound represented by the following formula 3:

[Formula 3]

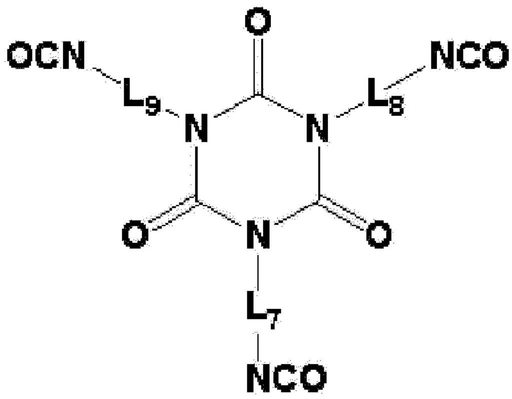

wherein, $L_7$, $L_8$ and $L_9$ are each independently an alkylene group, an alkenylene group or an alkynylene group.

**10.** The composition according to claim 1, wherein the filler component comprises 60 wt% or more of the filler having a specific gravity of 3 or more.

**11.** The composition according to claim 1, wherein the filler component comprises the filler having a specific gravity of less than 3 in an amount of 10 to 65 parts by weight relative to 100 parts by weight of the filler having a specific gravity of 3 or more.

**12.** The composition according to claim 1, wherein a ratio of the filler having a specific gravity of less than 3 in the filler

component is in a range of 10 to 50 wt%.

**13.** The composition according to claim 1, wherein the filler component comprises a first filler having a specific gravity of 3 or more and a D50 particle size in a range of 50 to 200 μm and a second filler having a specific gravity of 3 or more and a D50 particle size in a range of 0.5 to 5 μm.

**14.** The composition according to claim 13, wherein a ratio of the first filler in the filler component is in a range of 25 to 50 wt%.

**15.** The composition according to claim 13, wherein a ratio of the second filler in the filler component is in a range of 10 to 50 wt%.

**16.** The composition according to claim 13, wherein the second filler has a rectangular shape.

**17.** The composition according to claim 13, wherein the filler component further comprises a third filler having a specific gravity of 3 or more and a D50 particle size in a range of 10 to 30 μm.

**18.** The composition according to claim 17, wherein a weight ratio (C3/C2) of the third filler (C3) to the second filler (C2) is 1 or less.

**19.** The composition according to claim 1, wherein the filler having a specific gravity of less than 3 has a D50 particle size in a range of 50 to 90 μm.

**20.** The composition according to claim 1, wherein the cured product has a thermal conductivity of 3 W/m K or more.

**21.** A product comprising a heating element; and the composition of claim 1 or a cured product thereof in thermal contact with the heating element.

# INTERNATIONAL SEARCH REPORT

International application No.
**PCT/KR2022/001597**

## A. CLASSIFICATION OF SUBJECT MATTER

**C09J 11/04**(2006.01)i; **C09J 201/00**(2006.01)i; **C08K 3/013**(2018.01)i; **C08K 5/29**(2006.01)i; **C08K 3/08**(2006.01)i

According to International Patent Classification (IPC) or to both national classification and IPC

## B. FIELDS SEARCHED

Minimum documentation searched (classification system followed by classification symbols)

C09J 11/04(2006.01); B32B 15/08(2006.01); C08G 18/69(2006.01); C08G 18/79(2006.01); C08J 5/24(2006.01); C08L 83/05(2006.01); C08L 83/07(2006.01); C09J 163/00(2006.01); C09J 9/02(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: eKOMPASS (KIPO internal), STN (Registry, Caplus) & keywords: 필러 (filler), 수지 (resin), 이소시아네이트 화합물 (isocyanate compound)

## C. DOCUMENTS CONSIDERED TO BE RELEVANT

| Category* | Citation of document, with indication, where appropriate, of the relevant passages | Relevant to claim No. |
|---|---|---|
| A | JP 2020-029524 A (SHIN-ETSU CHEMICAL CO., LTD.) 27 February 2020 (2020-02-27)<br>See abstract; and claims 1-7. | 1-21 |
| A | CN 108440971 A (SUZHOU BAI MIN ELECTRONIC MATERIALS SCIENCE AND TECHNOLOGY LTD.) 24 August 2018 (2018-08-24)<br>See claims 1-8. | 1-21 |
| A | JP 5830940 B2 (HITACHI CHEM CO., LTD.) 09 December 2015 (2015-12-09)<br>See entire document. | 1-21 |
| A | CN 105026451 A (DAI-ICHI KOGYO SEIYAKU CO., LTD.) 04 November 2015 (2015-11-04)<br>See entire document. | 1-21 |
| A | KR 10-2015-0100621 A (SUMITOMO METAL MINING CO., LTD.) 02 September 2015 (2015-09-02)<br>See entire document. | 1-21 |

☐ Further documents are listed in the continuation of Box C. ☑ See patent family annex.

* Special categories of cited documents:
- "A" document defining the general state of the art which is not considered to be of particular relevance
- "D" document cited by the applicant in the international application
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| **09 May 2022** | **09 May 2022** |
| Name and mailing address of the ISA/KR<br>**Korean Intellectual Property Office**<br>**Government Complex-Daejeon Building 4, 189 Cheongsa-ro, Seo-gu, Daejeon 35208**<br>Facsimile No. **+82-42-481-8578** | Authorized officer<br><br>Telephone No. |

Form PCT/ISA/210 (second sheet) (July 2019)

**INTERNATIONAL SEARCH REPORT**
**Information on patent family members**

International application No.
**PCT/KR2022/001597**

| Patent document cited in search report | | | Publication date (day/month/year) | Patent family member(s) | | | Publication date (day/month/year) |
|---|---|---|---|---|---|---|---|
| JP | 2020-029524 | A | 27 February 2020 | TW | 202020053 | A | 01 June 2020 |
| | | | | WO | 2020-039761 | A1 | 27 February 2020 |
| CN | 108440971 | A | 24 August 2018 | | None | | |
| JP | 5830940 | B2 | 09 December 2015 | CN | 102918076 | A | 06 February 2013 |
| | | | | CN | 102918107 | A | 06 February 2013 |
| | | | | CN | 102918107 | B | 05 October 2016 |
| | | | | CN | 105669952 | A | 15 June 2016 |
| | | | | CN | 105669952 | B | 29 May 2018 |
| | | | | EP | 2578613 | A1 | 10 April 2013 |
| | | | | EP | 2578613 | B1 | 07 November 2018 |
| | | | | EP | 2578613 | B8 | 19 December 2018 |
| | | | | EP | 2578632 | A1 | 10 April 2013 |
| | | | | EP | 2578632 | B1 | 30 October 2019 |
| | | | | HK | 1179290 | A1 | 27 September 2013 |
| | | | | JP | 2012-012588 | A | 19 January 2012 |
| | | | | JP | 2012-012589 | A | 19 January 2012 |
| | | | | JP | 2012-012590 | A | 19 January 2012 |
| | | | | JP | 2012-012591 | A | 19 January 2012 |
| | | | | JP | 2016-104891 | A | 09 June 2016 |
| | | | | JP | 2016-153497 | A | 25 August 2016 |
| | | | | JP | 5866806 | B2 | 24 February 2016 |
| | | | | JP | 5961923 | B2 | 03 August 2016 |
| | | | | JP | 5966258 | B2 | 10 August 2016 |
| | | | | JP | 6304294 | B2 | 04 April 2018 |
| | | | | KR | 10-1803115 | B1 | 29 November 2017 |
| | | | | KR | 10-1938895 | B1 | 15 January 2019 |
| | | | | KR | 10-2013-0082448 | A | 19 July 2013 |
| | | | | KR | 10-2013-0103331 | A | 23 September 2013 |
| | | | | TW | 201213381 | A | 01 April 2012 |
| | | | | TW | 201213410 | A | 01 April 2012 |
| | | | | TW | I516518 | B | 11 January 2016 |
| | | | | TW | I527850 | B | 01 April 2016 |
| | | | | US | 2013-0108843 | A1 | 02 May 2013 |
| | | | | US | 2013-0126218 | A1 | 23 May 2013 |
| | | | | US | 8980424 | B2 | 17 March 2015 |
| | | | | US | 9215803 | B2 | 15 December 2015 |
| | | | | WO | 2011-152412 | A1 | 08 December 2011 |
| | | | | WO | 2011-152413 | A1 | 08 December 2011 |
| CN | 105026451 | A | 04 November 2015 | JP | 2015-089909 | A | 11 May 2015 |
| | | | | JP | 5550161 | B1 | 16 July 2014 |
| | | | | MY | 155770 | A | 25 November 2015 |
| | | | | WO | 2015-068418 | A1 | 14 May 2015 |
| KR | 10-2015-0100621 | A | 02 September 2015 | CN | 104822789 | A | 05 August 2015 |
| | | | | CN | 104822789 | B | 28 September 2016 |
| | | | | JP | 6156393 | B2 | 05 July 2017 |
| | | | | TW | 201430099 | A | 01 August 2014 |
| | | | | TW | I599636 | B | 21 September 2017 |
| | | | | WO | 2014-103569 | A1 | 03 July 2014 |

Form PCT/ISA/210 (patent family annex) (July 2019)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- KR 1020210017013